# EUROPEAN PATENT APPLICATION

(11) **EP 3 640 985 A1**
(43) Date of publication of application: **22.04.2020**
(21) Application number: 17899227.7
(22) Date of filing: 11.12.2017
(51) Int. Cl.: H01L 27/12, H01L 21/77

(54) **ARRAY SUBSTRATE AND MANUFACTURING METHOD THEREOF, DISPLAY PANEL, AND DISPLAY DEVICE**

(30) Priority: 08.06.2017 CN 201710426034
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: LI, Zihua, Beijing 100176 (CN); LIU, Jing, Beijing 100176 (CN); LIU, Qi, Beijing 100176 (CN); MA, Qun, Beijing 100176 (CN)
(74) Representative: Jacobacci Coralis Harle
(86) International application number: PCT/CN2017/115424
(87) International publication number: WO 2018/223642

(57) **Abstract**

The present disclosure relates to an array substrate, a method for fabricating the same, a display panel, and a display device. The array substrate includes an active layer on a substrate, the active layer including a channel region, source/drain regions positioned on both sides of the channel region, and a lightly doped drain region between the channel region and the source/drain region; a gate electrode and a first electrode on the active layer; and a gate electrode and the first electrode a first insulating layer; a barrier and a second electrode on the first insulating layer. A projection of the second electrode on the substrate at least partially overlaps that of the first electrode. A projection of the barrier on the substrate covers that of the lightly doped drain region on the substrate. The projection of the barrier portion on the substrate does not overlap that of the source/ drain regions. The barrier and the second electrode are in the same layer.

## Description

### CROSS-REFERENCE TO RELATED APPLICATIONS

This application claims priority from Chinese Patent Application No. 201710426034.0 filed on Jun. 8, 2017, the entire contents of which are hereby incorporated by reference.

### FIELD

The present disclosure relates to the field of display technology. More specifically, it relates to an array substrate, a method for fabricating the same, a display panel, and a display device.

### BACKGROUND

Thin film transistors (TFTs) are widely used in display technology. However, a crystal-damaged region caused by doping may occur in the TFT. This damaged region tends to cause hot carrier stress. For example, when electrons accelerate from the source region to the drain region, they may penetrate the gate insulating layer or the metal oxide semiconductor (MOS) interface. In addition, hot carrier stress may reduce the electron mobility and may also increase the off-current. This will have an adverse effect on the TFT.

An aging process has been proposed to reduce the leakage current in the TFT. However, the aging process will bring about new adverse effects. For example, it will lead to burns, new bright spots, abnormal display and so on.

Another known solution is to use a lightly doped drain region (LDD) to reduce the leakage current in the TFT. However, the process of the LDD in prior art is a complicated process and is also difficult to design.

### SUMMARY

A first aspect of the present disclosure provides an array substrate. The array substrate includes: a channel region, source/drain regions positioned on both sides of the channel region, and a lightly doped drain region between the channel region and the source/drain regions; a gate electrode and a first electrode positioned on the active layer; a first insulating layer positioned on the gate electrode and the first electrode; a barrier and a second electrode positioned on the first insulating layer, wherein a projection of the second electrode on the substrate at least partially overlaps a projection of the first electrode on the substrate, wherein a projection of the barrier on the substrate covers a projection of the lightly doped drain region on the substrate, wherein the projection of the barrier on the substrate does not overlap projections of the source/drain region on the substrate, and wherein the barrier and the second electrode are disposed in the same layer.

In an embodiment, the barrier has an opening, wherein a projection of the opening on the substrate at least partially overlaps the projection of the gate electrode on the substrate.

In an embodiment, a width of the lightly doped drain region ranges from about 0.5 µm to 1 µm.

In an embodiment, the array substrate further includes: a second insulating layer disposed between the active layer and the gate electrode; a via penetrating through the first insulating layer and the second insulating layer; source/drain electrodes positioned on the first insulating layer, the source/drain electrodes being in contact with the source/drain regions via the via.

In an embodiment, a doping concentration of the source/drain region is greater than a doping concentration of the lightly doped drain region, and wherein the doping concentration of the source/drain region ranges from about 4.5×10¹⁵ to about 6×10¹⁵ ions/cm³ and the doping concentration of the lightly doped drain region ranges from about 5×10¹² to about 4.5×10¹⁵ ions/cm³.

A second aspect of the present disclosure provides a display panel. The display panel includes the array substrate as described above.

A third aspect of the present disclosure provides a display device. The display device includes the display panel as described above.

A fourth aspect of the present disclosure provides a method for fabricating an array substrate. The method for fabricating an array substrate comprises: forming an active layer on a substrate; forming a gate electrode and a first electrode on the active layer; forming a first insulating layer on the gate electrode and the first electrode; forming a barrier material layer on the first insulating layer; performing one patterning process on the barrier material layer to form a barrier and a second electrode, wherein a projection of the second electrode on the substrate at least partially overlaps a projection of the first electrode on the substrate, wherein a projection of a portion of the barrier extending outward from a side of the gate electrode on the substrate is within a projection of a portion of the active layer extending outward from a side of the active layer on the substrate; performing a first doping on the active layer by using the barrier as a mask to form source/drain regions on both sides of the channel region of the active layer and a lightly doped drain region between the channel region and the source/drain regions.

In an embodiment, the barrier has an opening, and wherein a projection of the opening on the substrate at least partially overlaps a projection of the gate electrode on the substrate.

In an embodiment, the width of the lightly doped drain region ranges from about 0.5 µm to about 1 µm.

In an embodiment, a doping energy of the first doping is about 30Kev∼40Kev.

In an embodiment, a doping concentration of the source/drain regions is greater than a doping concentration of the lightly doped drain region, and wherein the doping concentration of the source/drain regions is about 4.5×10¹⁵ to about 6×10¹⁵ ions/cm³, and the doping concentration of the lightly doped drain (LDD) region is about 5×10¹² to about 4.5×10¹⁵ ions/cm³.

In an embodiment, a conductivity type of the channel region is N-type, and wherein a conductivity type of the lightly doped drain region and a conductivity type of doping regions of the source/drain regions are P type.

In an embodiment, the method for fabricating the array substrate further comprises: before forming the gate electrode and the first electrode, forming a second insulating layer on the active layer; after forming the source/drain regions, forming a via penetrating through the first insulating layer and the second insulating layer; and forming source/drain electrodes on the first insulating layer, wherein the source/drain electrodes are in contact with the source/drain regions through the via.

In an embodiment, forming the gate electrode and the first electrode includes: forming a gate electrode material layer on the second insulating layer; patterning the gate electrode material layer to form the gate electrode and the first electrode.

In an embodiment, the fabricating method of the array substrate further includes, after forming the gate electrode and the first electrode, doping the active layer by using the gate electrode as a mask to define a channel region of the active layer.

### DESCRIPTION OF THE DRAWINGS

In order to more clearly explain the technical solutions of the embodiments of the present disclosure, the following will briefly explain the drawings of the embodiments. It should be understood that the drawings described below merely relate to some embodiments of the present disclosure but are not intended to limit the present disclosure, in which:
FIG. 1 (a) is a schematic view of an array substrate according to an embodiment of the present disclosure;
FIG. 1(b) is a schematic view of an array substrate according to an embodiment of the present disclosure;
FIG. 2 is a schematic view of an array substrate according to an embodiment of the present disclosure;
FIG. 3 is a schematic view of an array substrate according to an embodiment of the present disclosure;
FIG. 4 is a schematic flowchart of a method for fabricating an array substrate according to an embodiment of the present disclosure;
FIG. 5 is a schematic flowchart of a method for fabricating an array substrate according to an embodiment of the present disclosure;
FIGS. 6(A)-6(F) are process flow diagrams of a method for fabricating an array substrate according to an embodiment of the present disclosure.

### DETAILED DESCRIPTION

In order that objects, technical solutions and advantages of embodiments of the present disclosure will become more apparent, the technical solutions of the embodiments of the present disclosure will be clearly and completely described below with reference to the accompanying drawings. Obviously, the described embodiments are a part of the embodiments of the present disclosure, but not all embodiments. Based on the described embodiments of the present disclosure, all other embodiments obtained by those skilled in the art without the need for creative work fall within the scope of the present disclosure.

When describing elements of the disclosure and their embodiments, the articles "a," "an," "this" and "the" are intended to indicate the presence of one or more elements. Words "contain", "comprise", "have" and "with" are intended to be inclusive and mean that additional elements other than the listed elements may be present. As used herein and in the appended claims, the singular form of a word includes the plural, and vice versa, unless the context clearly dictates otherwise. Thus, the references "a", "an", and "the" are generally inclusive of the plurals of the respective terms. Similarly, the words "comprise", "comprises", and "comprising" are to be interpreted inclusively rather than exclusively. Likewise, the terms "include", "including" and "or" should all be construed to be inclusive, unless such a construction is clearly prohibited from the context. Where used herein the term "examples," particularly when followed by a listing of terms is merely exemplary and illustrative, and should not be deemed to be exclusive or comprehensive.

For the purpose of the following description of the surface, as in the direction in which they are marked, the terms "upper", "lower", "left", "right", "vertical", "horizontal", "top", "bottom" and their derivatives shall relate to the disclosure. The terms "overlying", "on top of', "positioned on", or "positioned on top of' means that a first element, such as a first structure, is present on a second element, such as a second structure, wherein an intermediate element such as an interface structure may exist between the first element and the second element. The term "contact" means connecting a first element, such as a first structure, and a second element, such as a second structure, with or without other elements at the interface of the two elements.

Embodiments of the present disclosure provide an array substrate comprising an active layer positioned on a substrate, the active layer including a channel region, source/drain regions positioned on both sides of the channel region, and a lightly doped drain region between the channel region and the source/drain regions; a gate electrode and a first electrode positioned on the active layer; a first insulating layer positioned on the gate electrode and the first electrode; a barrier provided on the first insulating layer and the second electrode, wherein a projection of the second electrode on the substrate at least partially overlaps a projection of the first electrode on the substrate, a projection of the barrier on the substrate covers a projection of the lightly doped drain region on the substrate, the projection of the barrier on the substrate does not overlay with a projection of the source/drain regions on the substrate, and wherein the barrier and the second electrode layer are disposed in the same layer. Here, being disposed in the same layer means being formed by the same film.

The embodiments of the present disclosure will be further described below with reference to the accompanying drawings.

FIG. 1 (a) is a schematic view of an array substrate according to an embodiment of the present disclosure. As shown in FIG. 1(a), an array substrate according to an embodiment of the present disclosure includes an active layer 11 positioned on a substrate 10 , the active layer 11 including a channel region 11C ,source/drain regions 11SD positioned on sides of the channel region 11C and a lightly doped drain region 11L disposed between the channel region 11C and the source/drain regions 11SD; a gate electrode 121 and a first electrode 122 positioned on the active layer 11; a first insulating layer 13 provided on the gate electrode 121 and the first electrode 122; a barrier 141 and a second electrode 142 provided on the first insulating layer 13. A projection of the second electrode 142 on the substrate 10 at least partially overlaps a projection of the first electrode 122 on the substrate 10. A projection of the barrier 141 on the substrate 10 covers a projection of the lightly doped drain region 11L on the substrate 10, and the projection of the barrier 141 on the substrate 10 does not overlap a projection of the source/drain regions 11SD on the substrate 10 do not overlap (in other words, the edge of the barrier 141 away from the gate electrode 121 is aligned with the edge of the lightly doped drain region 11L away from the gate electrode 121). The barrier 141 and the second electrode 142 are disposed in the same layer and have the same material. Herein, the "the edge of the barrier away from the gate electrode is aligned with the edge of the lightly doped drain region away from the gate electrode" refers to the outer boundary of the projection of the barrier on the substrate and the outer boundary of the projection of the lightly doped drain region substantially overlap.

The first electrode and the second electrode may form a capacitance to maintain a stable voltage. For example, when being used in an OLED structure, since the capacitance including the first electrode and the second electrode can maintain the stability of the voltage of the driving transistor in one cycle, the current of the OLED in one cycle is also stabilized. Therefore, OLED's luminous uniformity and stability can be ensured.

In FIG. 1(a), a lightly doped drain region 11L is exemplified as being provided on both sides of the channel region. However, the position of the lightly doped drain region can be set according to actual needs. For example, as shown in FIG. 1(b), the lightly doped drain region may be located only on one side of the channel region. FIG. 1(b) shows the case where a region of the source/drain regions far from the first electrode is used as a drain region, and a lightly doped drain can be provided only on the side of the channel region far from the first electrode. Of course, when a region of the source/drain regions close to the first electrode is used as a drain region, a lightly doped drain region may also be provided only on the side of the channel region near the first electrode.

By the lightly doped drain region, the leakage current of the thin film transistor can be reduced. Due to the same layer arrangement of the second electrode and the barrier, the two can be formed using a single patterning process. In this way, when forming the second electrode and the barrier, only one mask is used, the fabricating process of the array substrate thus can be simplified. The production yield can be improved and the cost can also be saved.

FIG. 2 is a schematic view of an array substrate according to an embodiment of the present disclosure. As shown in FIG. 2, the barrier may have an opening P. A projection of the opening P on the substrate 10 at least partially overlaps a projection of the gate electrode 121 on the substrate 10. By providing such an opening in the barrier, it is possible to prevent or reduce the parasitic capacitance that may be generated between the barrier and the gate electrode.

In an embodiment, the width of the lightly doped drain region (which also corresponds to a distance d between the projection of the edge of the barrier 141 away from the gate electrode 121 on the substrate 10 and the projection of the channel region 11C on the substrate 10) ranges from about 0.5µm to about 1 µm. With such a distance setting, it is possible to better reduce the leakage current of the transistor.

FIG. 3 is a schematic view of an array substrate according to an embodiment of the present disclosure. As shown in FIG. 3, the array substrate according to an embodiment of the present disclosure further includes a second insulating layer 15 disposed between the active layer 11 and the gate electrode 121, a via 15 penetrating through the first insulating layer 13 and the second insulating layer; source/drain electrodes 16 provided on the first insulating layer 13. The source/drain electrodes 16 are in contact with the source/drain regions 11SD through the via V.

In an embodiment, the conductivity type of the channel region may be N type, and the doping type of the lightly doped drain region and the conductivity type of the doped region of the source/drain regions may be P type. It can be understood that the doping concentration of the source/drain regions is greater than the doping concentration of the lightly doped drain region. In an embodiment, the doping concentration of the source/drain regions may range from about 4.5×10¹⁵ to about 6×10¹⁵ ions/cm³, and the doping concentration of the lightly doped drain (LDD) region may range from about 5×10¹² to about 4.5 × 10¹⁵ ions/cm³.

Another aspect of the present disclosure provides a method for fabricating an array substrate.

FIG. 4 is a schematic flowchart of a method for fabricating an array substrate according to an embodiment of the present disclosure. As shown in FIG. 4, a fabricating method of an array substrate according to an embodiment of the present disclosure includes:
S101: forming an active layer on the substrate;
S103: forming a gate electrode and a first electrode on the active layer;
S105: forming a first insulating layer on the gate electrode and the first electrode;
S107: forming a barrier material layer on the first insulating layer;
S109: performing a patterning process on the barrier material layer to form a barrier and a second electrode. A projection of the second electrode on the substrate at least partially overlaps a projection of the first electrode on the substrate. A projection of a portion of the barrier extending outward from a side of the gate electrode on the substrate is within a projection of a portion of the active layer extending outward from a side of the active layer on the substrate.
S111: performing a first doping on the active layer, by using the barrier as a mask, to form source/drain regions on both sides of the channel region of the active layer and a lightly doped drain region between the channel region and the source/drain regions.

In an embodiment, the barrier may have an opening. A projection of the opening on the substrate at least partially overlaps a projection of the gate electrode on the substrate. By the opening in the barrier, it is possible to prevent or reduce the parasitic capacitance that may be generated between the barrier and the gate electrode.

In an embodiment, the lightly doped drain region (corresponding to the distance d between the projection of the edge of the barrier far from the gate electrode on the substrate and the projection of the channel region onto the substrate) is approximately 0.5 µm∼1µm. With such a distance setting, it is possible to better reduce the leakage current of the transistor.

In an embodiment, the first doped doping energy may be about 30 Kev to about 40 Kev. The conductivity type of the channel region may be N type, and the doping type of the lightly doped drain region and the conductivity type of the doped region of the source/drain region may be P type. The doping concentration of the source/drain region may range from about 4.5×10¹⁵ to about 6×10¹⁵ ions/cm³, and the doping concentration of the lightly doped drain (LDD) region may range from about 5×10¹² to about 4.5 × 10¹⁵ ions/cm³.

The material of the second conductive layer may be selected from Molybdenum (Mo), MoNb, Al, AlNd, Ti, Cu or combinations thereof.

FIG. 5 is a schematic flowchart of a method for fabricating an array substrate according to an embodiment of the present disclosure. As shown in FIG. 5, in an embodiment, the method for fabricating an array substrate further includes:
S102: Before forming the gate electrode and the first electrode, forming a second insulating layer on the active layer.
S104: After forming the gate electrode and the first electrode, doping the active layer with the gate electrode as a mask to define a channel region of the active layer.
S113: After forming the source/drain regions, forming a via penetrating through the first insulating layer and the second insulating layer.
S115: Forming source/drain electrodes on the first insulating layer, wherein the source/drain electrodes are in contact with the source/drain regions through the via.

In an embodiment, forming the gate electrode and the first electrode includes: forming a gate electrode material layer on the second insulating layer; patterning the gate electrode material layer to form the gate electrode and the first electrode.

FIGS. 6(A)-6(F) are process flow diagrams of a method for fabricating an array substrate according to an embodiment of the present disclosure. A method for fabricating an array substrate according to an embodiment of the present disclosure will be further described below with reference to FIG. 6.

As shown in FIG. 6(A), a method for fabricating an array substrate according to an embodiment of the present disclosure includes:
Form the active layer 11 on the substrate 10. The substrate may include a glass substrate, and may also include any material suitable for a substrate such as a high molecular polymer, a metal foil, or the like. The active layer may include a silicon material. Since the low temperature polysilicon material has an electron mobility superior to that of the amorphous silicon material, the active layer may include a polysilicon material. In an embodiment, an amorphous silicon layer may be formed on a substrate, then an amorphous silicon may be subjected to an excimer laser annealing (ELA) process so that the amorphous silicon becomes polysilicon. Then perform a doping with a first conductivity type on the polysilicon. For example, when the first conductivity type is N-type, a doping dose of 1×10¹² to 2×10¹² ions/cm³ may be used. In an embodiment, P-type silicon may be provided and then an N-well may be formed on the P-type silicon. The upper surface of the N-well is on the same surface as the upper surface of the P-type silicon. Of course, it is understood that the active layer having the first conductivity type may also be directly provided without the above-described doping step.

Next, a second insulating layer 15 is formed on the active layer 11. The material of the second insulating layer may be selected from the group consisting of silicon oxide (SiOx), silicon nitride (SiNx), hafnium oxide (HfOx), silicon nitride oxide (SiON), AlOx, and any combination thereof.

Then, the gate electrode 121 and the first electrode 122 are formed on the second insulating layer 15. Specifically, a gate electrode material layer may be formed on the second insulating layer, and then the gate electrode material layer may be patterned to form the gate electrode 121 and the first electrode 122. The gate electrode material layer may be selected from a group consisting of Molybdenum (Mo), MoNb, Al, AINd, Ti, and Cu, and any combinations thereof.. A doping with a second conductivity type is then performed with the gate electrode and the first electrode as masks. For example, when the first conductivity type of the active layer is N-type, the second conductivity type is then P-type. In the situation that the second conductivity type is P-type, a doping dose ranging from 5×10¹² to 4.5×10¹⁵ ions/cm³ may be used.

As shown in FIG. 6(B), a first insulating layer 13 is further formed on the gate electrode 121 and the first electrode 122. The material of the first insulating layer may be selected from a group consisting of silicon oxide (SiOx), silicon nitride (SiNx), hafnium oxide (HfOx), silicon nitride oxide (SiON), AlOx and any combination thereof.

As shown in FIG. 6(C), a barrier material layer 14 is further formed on the first insulating layer 13. The barrier material layer may be selected from a group consisting of Molybdenum (Mo), MoNb, Al, AINd, Ti, and Cu and any combinations thereof.

Then, as shown in FIG. 6(D), the barrier material layer 14 is processed by one patterning process to form the barrier 141 and the second electrode 142. For example, the specific steps may be: forming a photoresist on the barrier material layer; exposing the photoresist with a mask including a pattern of the barrier and the second electrode; performing a developing; and then using the photoresist as a protective layer to etch the barrier material layer; and finally remove the photoresist. As can be seen from FIG. 6(D), the projection of the second electrode on the substrate at least partially overlaps the projection of the first electrode on the substrate, and the portion of the barrier extending outward from a side of the gate electrode is within the projection of the portion of the active layer extending outward from the side of the gate electrode on the substrate (in other words, a projection of the edge of the barrier away from the gate electrode on the substrate is between a projection of the edge of the active layer away from the gate electrode on the substrate and a projection of the corresponding edge of the gate electrode on the substrate). In the process of forming the barrier and the second electrode, only one mask is used, thus the process can be simplified. Therefore, the cost can be saved and the yield can be improved.

The barrier portion may have an opening P. The projection of the opening P on the substrate 10 at least partially overlaps the projection of the gate electrode 121 on the substrate 10. By such an opening in the barrier, it is possible to prevent or reduce the parasitic capacitance that may be generated between the barrier and the gate electrode.

The distance of the projection of the edge of the barrier away from the gate electrode on the substrate to a projection of the channel region to the substrate (corresponding to the width of the subsequently formed lightly doped drain region) may range from about 0.5 µm to about 1µm. With such a distance setting, it is possible to better reduce the leakage current of the transistor.

Then, as shown in FIG. 6(E), a first doping is performed on the active layer 11 using the barrier as a mask 141 to form source/drain regions 11SD on both sides of the channel region 11C of the active layer 11 and a lightly doped drain region 11L disposed between the channel region 11C and the source/drain regions 11SD. For the case where the conductivity type of the active layer is an N type, P type doping may be used so that the conductivity type of the lightly doped drain region and the doped region of the source/drain regions formed after this doping is P type. The doping energy may range from about 30Kev to about40Kev. It can be understood that the doping concentration of the source/drain regions is greater than the doping concentration of the lightly doped drain region. In an embodiment, the formed source/drain regions may have a doping concentration ranges from about 4.5×10¹⁵ to about 6×10¹⁵ ions/cm³, and the lightly doped drain region may have a doping concentration ranges from about 5×10¹² to about 4.5×10¹⁵ ions/cm³.

Next, as shown in FIG. 6(F), vias V is formed through the first insulating layer 13 and the second insulating layer 15, and the source/drain electrodes 16 are formed on the first insulating layer 13. It can be seen that the source/drain electrodes 16 are in contact with the source/drain regions 11SD through the vias V.

The embodiments of the present disclosure also provide a display panel and a display device. The display panel in the embodiment of the present disclosure includes the array substrate as described above. The display device in the embodiments of the present disclosure may be any product or component having a display function such as a mobile phone, a tablet computer, a television, a notebook computer, a digital photo frame, a navigator, and the like.

Having described certain specific embodiments, these embodiments have been presented by way of example only, and are not intended to limit the scope of the present disclosure. Indeed, the novel embodiments described herein may be embodied in various other forms; furthermore, various omissions, substitutions and changes in the form of the embodiments described herein may be made without departing from the spirit of the disclosure. The accompanying claims and their equivalents are intended to cover such forms or modifications as would fall within the scope and spirit of the disclosure.

## Claims

1. An array substrate, comprising:
an active layer positioned on a substrate, the active layer comprising a channel region, source/drain regions positioned on both sides of the channel region, and a lightly doped drain region between the channel region and the source/drain regions;
a gate electrode and a first electrode positioned on the active layer;
a first insulating layer positioned on the gate electrode and the first electrode;
a barrier and a second electrode positioned on the first insulating layer, wherein a projection of the second electrode on the substrate at least partially overlaps a projection of the first electrode on the substrate, wherein a projection of the barrier on the substrate covers a projection of the lightly doped drain region on the substrate, wherein the projection of the barrier on the substrate does not overlap projections of the source/drain region on the substrate, and wherein the barrier and the second electrode are disposed in the same layer.

2. The array substrate according to claim 1, wherein the barrier portion has an opening, wherein a projection of the opening on the substrate at least partially overlaps the projection of the gate electrode on the substrate.

3. The array substrate according to claim 2, wherein a width of the lightly doped drain region ranges from about 0.5 µm to about 1 µm.

4. The array substrate according to any one of claims 1 to 3, wherein the array substrate further comprises: a second insulating layer disposed between the active layer and the gate electrode;
a via penetrating through the first insulating layer and the second insulating layer;
source/drain electrodes positioned on the first insulating layer, the source/drain electrodes being in contact with the source/drain regions via the via.

5. The array substrate according to claim 41, wherein a doping concentration of the source/drain region is greater than a doping concentration of the lightly doped drain region, and wherein the doping concentration of the source/drain region ranges from about 4.5×10¹⁵ to about 6×10¹⁵ ions/cm³ and the doping concentration of the lightly doped drain region ranges from about 5×10¹² to about 4.5×10¹⁵ ions/cm³.

6. The array substrate according to any one of claims 1-5, wherein the active layer comprises low-temperature polysilicon.

7. A display panel comprising the array substrate according to any one of claims 1-6.

8. A display device comprising the display panel according to claim 7.

9. A method for fabricating an array substrate, comprising: forming an active layer on a substrate;
forming a gate electrode and a first electrode on the active layer;
forming a first insulating layer on the gate electrode and the first electrode; forming a barrier material layer on the first insulating layer;
performing one patterning process on the barrier material layer to form a barrier and a second electrode, wherein a projection of the second electrode on the substrate at least partially overlaps a projection of the first electrode on the substrate, wherein a projection of a portion of the barrier extending outward from a side of the gate electrode on the substrate is within a projection of a portion of the active layer extending outward from a side of the active layer on the substrate;
performing a first doping on the active layer by using the barrier as a mask to form source/drain regions on both sides of the channel region of the active layer and a lightly doped drain region between the channel region and the source/drain regions.

10. The method for fabricating an array substrate according to claim 9, wherein the barrier has an opening, and wherein a projection of the opening on the substrate at least partially overlaps a projection of the gate electrode on the substrate .

11. The method for fabricating an array substrate according to claim 10, wherein the width of the lightly doped drain region ranges from about 0.5 µm to about 1 µm.

12. The method for fabricating an array substrate according to claim 9, wherein a doping energy of the first doping is about 30Kev∼40Kev.

13. The method for fabricating an array substrate according to claim 9, wherein a doping concentration of the source/drain regions is greater than a doping concentration of the lightly doped drain region, and wherein the doping concentration of the source/drain regions is about 4.5×10¹⁵ to about 6×10¹⁵ ions/cm³, and the doping concentration of the lightly doped drain region is about 5×10¹² to about 4.5×10¹⁵ ions/cm³.

14. The method for fabricating an array substrate according to claim 9, wherein a conductivity type of the channel region is N-type, and wherein a conductivity type of the lightly doped drain region and a conductivity type of doping regions of the source/drain regions are P type.

15. The method for fabricating an array substrate according to any one of claims 9 to 14, wherein the method for fabricating the array substrate further comprises: before forming the gate electrode and the first electrode, forming a second insulating layer on the active layer;
after forming the source/drain regions, forming a via penetrating through the first insulating layer and the second insulating layer; and
forming source/drain electrodes on the first insulating layer, wherein the source/drain electrodes are in contact with the source/drain regions through the via .

16. The method for fabricating an array substrate according to claim 15, wherein forming the gate electrode and the first electrode comprises:
forming a gate electrode material layer on the second insulating layer;
patterning the gate electrode material layer to form the gate electrode and the first electrode.

17. The method for fabricating an array substrate according to any one of claims 9 to 14, wherein the method for fabricating the array substrate further comprises,
after forming the gate electrode and the first electrode, doping the active layer by using the gate electrode as a mask to define a channel region of the active layer.
